# EUROPEAN PATENT APPLICATION

(11) **EP 1 107 581 A2**
(43) Date of publication of application: **13.06.2001**
(21) Application number: 00125894.6
(22) Date of filing: 27.11.2000
(51) Int. Cl.: H04N 3/15

(54) **Image pickup apparatus**

(30) Priority: 09.12.1999 DE 19959539
(71) Applicant: DEUTSCHE THOMSON-BRANDT GMBH, 78048 Villingen-Schwenningen (DE)
(72) Inventor: Schweer, Rainer, 78078 Niedereschach (DE)
(74) Representative: Schäferjohann, Volker Willi

(57) **Abstract**

Recently, so-called CMOS image sensors have been used as image recorders to an increasing extent in apparatuses appertaining to consumer electronics. These image sensors afford the advantage that they can be integrated on a particularly large scale and that other components can also be integrated with them on a chip. By way of example, the co-integration of an A/D converter operating at the pixel level has been disclosed. The invention provides an alternative embodiment of such an image recorder with co-integrated A/D converter. According to the invention, a comparator 113 is co-integrated per light-sensitive element (11), to which comparator the analogue value of the light sensor (111) is fed at one of its inputs and a ramp signal is fed at its other input. The output of the comparator (113) is connected to a trigger input of a register (14) having a width of N bits. The output pulse of the comparator causes the register (14) to buffer-store the instantaneous value of the ramp signal in digital form. The ramp signal is generated in such a way that it is incremented in fine steps up to a maximum value corresponding to the desired bit resolution for the A/D conversion. The buffer-stored instantaneous value of the ramp signal then corresponds to the converted analogue value of the light sensor (111). This solution affords the advantage that only one clock signal having a low clock frequency is required for generating the ramp signal. Furthermore, the solution can be integrated on a chip in a simple manner.

## Description

The invention relates to an image recorder which can be used e.g. in video cameras, digital cameras, etc. The term digital cameras is used here to mean apparatuses appertaining to digital photography.

Image recorders comprising a semiconductor image sensor have already been known for a relatively long time from the prior art. The first semiconductor image sensors related to so-called CCD arrays (charge coupled device) operating according to the so-called bucket brigade principle. Although CCD arrays are also manufactured on silicon wafers, they nonetheless require a special technology, which makes it more difficult to integrate other components on the same chip. Therefore, in these image recorders, the conversion of the charge accumulated by the light-sensitive elements into a digital value is performed outside the array, using a fast A/D converter.

Recently, so-called CMOS image sensors have also been used in apparatuses appertaining to consumer electronics. They are associated with a number of significant advantages. CMOS chip technology is widespread. That makes it possible to manufacture CMOS image sensors on the same production lines as also used for, for example, CMOS memory modules or CPUs. The production lines only have to be converted to a slight extent. Moreover, the CMOS image sensors afford the possibility of integration with other switching units on a chip. By way of example, the integration of the A/D converter with the CMOS image sensor on a chip has already been realized. However, thought has also been given to the integration of image optimization components and units for image compression.

An overview of the prior art in the context of CMOS image sensors can be found in the article "A Nyquist-Rate Pixel-Level ADC for CMOS Image Sensors" in IEEE journal of Solid-State Circuits, Volume 34, No. 3, March 1999, pages 348-356. This document describes a CMOS image sensor which likewise contains, co-integrated, an A/D converter per pixel. In this case, the basic construction for each pixel element is such that the charge stored by the light-sensitive element is applied to one input of a comparator. A ramp signal is passed to the other input of the comparator. The ramp signal corresponds to a staircase signal, that is to say rises continuously in a number of increments. A D flip-flop is connected downstream of the comparator. A clock signal derived from the ramp signal is applied to the D input of the flip-flop. The output of the comparator is connected to the trigger input G of the flip-flop. The clock signal derived from the ramp signal changes its logic state each time an increment is added to the ramp signal. The Q output of the flip-flop represents the digital output of the arrangement. This arrangement converts the analogue value present at the comparator into a digital value in a bit-serial manner. In this solution, the ramp signal has to be restarted per bit to be converted. By way of example, if it is desired to convert the stored analogue value with an m-bit resolution, then at least 2^{m} - 1 passes are necessary.

That is a considerable degree of complexity and, taking this prior art as a departure point, the object of the invention is to reduce the complexity for A/D converters which are co-integrated with CMOS image sensors.

### Invention

The object set is achieved by means of the features of the independent Claim 1.

In the image recorder according to the invention, means for converting the analogue value stored in a light-sensitive element into a digital value are likewise co-integrated, in which case these means can be apportioned, on the one hand to the sensor matrix itself and on the other hand to the periphery of the sensor matrix. It is also true that a comparator is provided per light-sensitive element, to which comparator the analogue value is fed at one input and a ramp signal is fed at the other input. Unlike the known solution, the output of the comparator is connected to a trigger input of a register having a width of N bits, where N is a natural number > 2. The number N corresponds to the number of bits of the digital value to be generated. The output pulse of the comparator causes the register to buffer-store the instantaneous value of the ramp signal in digital form. In this solution, therefore, the ramp signal is formed in such a way that it directly reflects the digital value to be converted. The solution affords the advantage that the ramp signal has to be generated only once per conversion, irrespective of the desired bit resolution. There is no need to provide an additional flip-flop per pixel in the image recorder.

Further advantages and improvements are possible by virtue of the measures presented in the dependent claims. In the case of a matrix-type arrangement of the light-sensitive elements, addressing in rows or in columns can be effected in such a way that the analogue values are converted in rows or in columns, in which case the number of registers which have a width of N bits and are arranged in parallel then only has to be as many as there are light-sensitive elements provided in a row or column. As a result, the integration complexity is reduced and only relatively few N-bit registers have to be provided.

In connection with the realization or conversion in rows or in columns, it is advantageous if the ramp signal is restarted cyclically, in each case for the conversion of the analogue values of a row or column.

The ramp signal should be constructed in such a way that it reflects the digital value at each instant. This can be realized in a simple manner. For this purpose, it is necessary merely for the entire range of analogue measured values to be encompassed by the ramp signal and the number of increments must correspond to the desired bit resolution. By way of example, if the intention is to achieve an 8-bit resolution, then the ramp signal must be incremented from 0-255 and the maximum of the range of analogue measured values must be reached at the maximum possible value 255.

It is advantageous in this connection if the increments of the ramp signal are variable, in particular are smaller in a first region than in a second region. The conversion behaviour can thus be adapted to the behaviour of the human eye. This is because the human eye responds less sensitively to changes in brightness when a certain basic brightness is exceeded. A finer resolution would thus be achieved in the lower brightness range.

Furthermore, it is advantageous if a shift register is also provided, into which the entries of the registers which have a width of N bits and are arranged in parallel are copied after the end of a ramp signal cycle. The fast recopying of the register contents into a shift register again creates free space in the registers for the conversion of the analogue values of the next row or column. The values accepted into the shift register can then be read out in order and be written to a conventional RAM memory or else a special image memory. This can then be done within the next ramp signal cycle and proceed in parallel with the conversion of the next row or column.

The ramp signal is advantageously generated in a counter with D/A converter connected downstream. For this solution, it is advantageous when the respective counter reading of the counter is passed to the inputs of the registers required for the A/D conversion. The output signal of the comparator generates the write pulse for a register and the register thus accepts the present counter reading available at the inputs.

If the image recorder is intended to be used for generating video images, then it is advantageous for the analogue values to be converted in rows and for the cycle of the ramp signal to correspond to the duration of a video line.

The image recorder according to the invention is advantageously manufactured using CMOS chip technology.

### Drawings

Exemplary embodiments of the invention are illustrated in the drawings and are explained in more detail in the description below. In the figures:
- Figure 1: shows a basic block diagram of a digital camera;
- Figure 2: shows a block diagram of the image recorder according to the invention;
- Figure 3: shows the components of the image recorder according to the invention which are to be provided per pixel;
- Figure 4: shows a block diagram of a ramp-signal generating device, and
- Figure 5: shows the ramp signal and the associated clock signals.

### Description of the invention

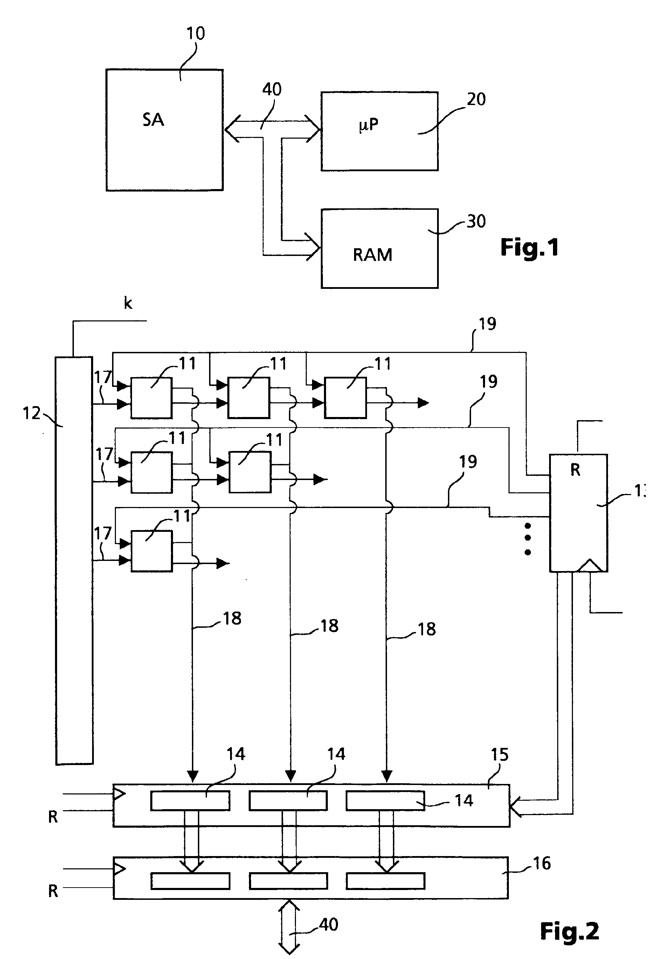

The invention is explained using the example of a digital camera. Such apparatuses are used to record still images (photographs) directly in digital form. Figure 1 shows a simplified block diagram of such an apparatus. The optical components of the digital camera have been omitted in Figure 1. They include, in particular, objective, diaphragm, shutter and also all the associated electronic auxiliaries, such as e.g. autofocus system, automatic time and diaphragm mechanism, flashlight generation, etc. A computer interface as is present has not been illustrated either. The reference numeral 10 designates a CMOS image recorder. Its construction will be explained in precise detail below. The CMOS image recorder 10 is connected to a microprocessor 20 via a data, address and control bus 40. A RAM memory 30 is also connected to the data, address and control bus 40. The recorded images are stored in the said RAM memory and can be transferred from there via the computer interface (already mentioned) to a personal computer, or else be transferred to a printer which can be used to print out the images. The transporting of the data of the CMOS image recorder 10 to the RAM memory 30 is controlled by the microprocessor 20. The latter can, given a corresponding design, also simultaneously undertake further control tasks within the digital camera. Examples mentioned include the automatic time and diaphragm mechanism already mentioned, and also the autofocus system and the flashlight control and also overall the processing of the user commands input via keys that are present.

The construction of the CMOS image recorder 10 is explained below with reference to Figure 2. The image recorder 10 comprises a matrix of light-sensitive CMOS light sensors 11. These CMOS light sensors 11 are each illustrated as a separate block in Figure 2. This is intended to indicate that it is not just the CMOS light sensor alone that is arranged in the respective block but also still further components which are important for the A/D conversion, which will be explained in more detail below. Each light-sensitive element detects the light for an individual pixel of the image to be recorded. It is desirable, therefore, to arrange as many CMOS light sensors as possible in the matrix. CMOS image recorders with more than a million light sensors have already been produced at the present time.

If colour images are intended to be recorded, it is necessary to record the three primary colours RGB separately in each case. This can be done for example by arranging three different CMOS image sensors 10 in the camera, to each of which the colour-filtered light is fed. In the three different image recorders, however, there is no change to the construction principle of the CMOS image sensors 10.

In order to read out the quantity of charge stored in the light sensors 11 after exposure of the image recorder, a row selector 12 is provided in Figure 2. The image lines are thereby selected individually. A corresponding control line per image line is routed to each light sensor 11 of an image line in Figure 2. These control lines are designated by the reference numeral 17. Within each light-sensitive cell 11, the row select signal serves for releasing the respective output line 18. The arrangement in the example of Figure 2 is chosen such that the output lines of the light sensors 11 of a column are all interconnected and routed out from the recording matrix via a single output line. The row select signal defines which of the light sensors 11 of a column is connected to the column output line 18. This ensures that the light sensors 11 of an image line can all be evaluated individually. For this purpose, a register block 15 is provided at the output of the matrix of light sensors. In this register block 15, there are as many registers 14 arranged in parallel as there are light sensors 11 present in an image line. The output lines 18 are each routed to a control input of the associated register 14. There may also be provided between register and output line 18 a respective amplifier stage, for signal conditioning. The register block 15 is additionally supplied with two clock signals, one of which is designated as the reset signal R. A special feature is, moreover, that the data inputs of the registers 14 are connected to data outputs of a ramp signal generating unit 13. In other words, all the registers 14 receive the same data input values. This will be discussed in more detail below.

The ramp signal generating device 13 has separate outputs for each image line. A ramp signal is in each case generated only for the selected image line. For ramp signal generation, a clock signal and a reset signal are fed to this device. The ramp signal output lines are designated by the reference numeral 19.

A shift register 16 is also arranged besides the register block 15. The said shift register serves for accepting the entries in the individual registers 14. Consequently, the data outputs of each register 14 are connected to the corresponding parallel inputs of the shift register 16. The register values are accepted at the end of a ramp signal cycle, which will be explained in greater detail later. If the data have been accepted into the shift register 16, they can be transferred into the RAM memory block 30 via the bus connection 40. This is then done by a number of shift operations corresponding to the number of data words stored in the shift register 16. The shift register 16 is preferably designed as a barrel shifter, in which shifting by more than one bit takes place within a clock cycle. Since the register words are always intended to be read out individually, the shifting per clock cycle should be effected by the number of bits corresponding to the width of the register word. In other words, a respective shift of 8 bits per clock cycle, given a register width of 8 bits.

For the explanation of the method of operation of the CMOS image recorder 10 described, it is advantageous if the construction of a light sensor 11 and the construction of the ramp signal generating unit 10 are explained beforehand.

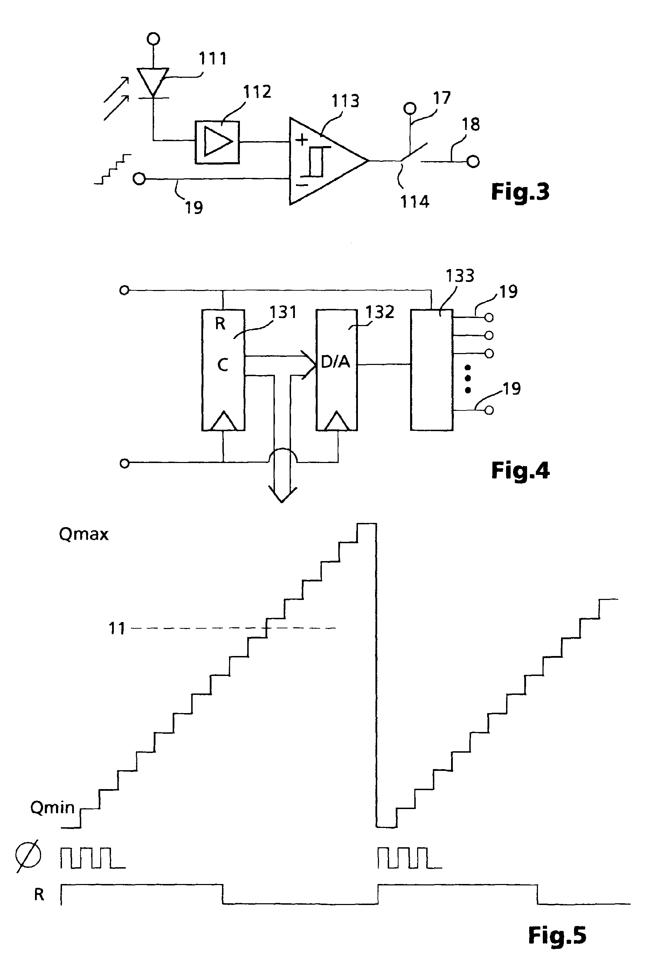

Figure 3 illustrates the construction of each light-sensitive cell 11. The light-sensitive element is designated by the reference numeral 111. A photodiode is chosen as the light-sensitive element in this case. Connected downstream of the photodiode is an amplifying transistor 112. The latter amplifies the charge which is generated by the photodiode and stored in a capacitance (not illustrated). The signal thus amplified is passed to an input of a comparator 113. The comparator 113 is designed e.g. as a Schmitt trigger in order that very fast switching is ensured. The ramp signal is applied to the further input of the comparator 113. A switch 114 is also provided between the output of the comparator 113 and the output of the light-sensitive cell 11, which switch may be embodied as a tristate driver, by way of example. The switch 114 is driven via the row select control line 17.

The ramp signal is illustrated by way of example in Figure 5. The example shown there involves a ramp signal which is incremented in 16 steps. The clock signal which controls the incrementing is illustrated directly below the ramp signal. The ramp signal is reset to zero after every 16^{th} incrementing step, this being controlled by a reset signal R. The reset signal can be derived from the clock signal.

The ramp signal is generated in the simplest way with the aid of a counter and a D/A converter connected downstream. This is illustrated in Figure 4. The reference numeral 131 designates the counter. The present counter reading in each case is applied to a D/A converter 132. The latter converts the counter reading into a corresponding analogue signal. The analogue signal then passes to a demultiplexing device 133, where it is directed to one of the outputs 19. The demultiplexer 133 receives the reset pulse as clock input, as a result of which the ramp signal is applied to the output 19 for the next image line. What is also important is that the present counter reading is likewise routed out from the ramp signal generating device 13. As explained above, the counter reading is applied to the data inputs of the registers 14 in the register block 15 of the CMOS image recorder 10.

The method of operation of the image recorder is now as follows: after exposure, the light-sensitive cells 11 are subjected to A/D conversion and read out in rows. The ramp signal is applied to all the cells of a selected image line synchronously with the reset pulse. The ramp signal begins at the value 0 and is then incremented up to the value 16 in 16 steps. During this cycle, the comparator 113 compares the two inputs with one another. A signal edge is generated and directed via the output 18 to the control input of the relevant register 14 if the ramp signal exceeds the analogue value present at the other input. This causes the register 14 to immediately buffer-store the present counter reading of the counter 131. An example of an analogue value that is present is indicated by a broken line in Figure 5. This value is only exceeded after the 11^{th} incrementing step. Therefore, the value 11 is stored as present counter reading in the associated register 14. There is a problem with this method in that the counter reading 0 is not detected. This is because the analogue value can only be exceeded after the first increment, after which, however, the counter reading already has the value 1. Therefore, in the solution shown here, instead of just a 4-bit counter that is inherently necessary for the values 0-15, a 5-bit counter is used which, however, is only counted from 0-16 and is then reset to zero by the reset pulse. It is then agreed that if the counter reading 1 has been buffer-stored in a register, this value is subsequently assigned the value zero and, for example, if the value 16 has been buffer-stored, this value is assigned the value 15. This can be done in a simple manner by the microprocessor 20 decrementing by 1 each value read from the shift register 16 and then storing it in this form in the RAM memory 30. Other solutions can also be applied to this problem, of course.

A 4-bit resolution in the A/D conversion is inadequate for digital photography. Resolutions of the order of magnitude of 10 bits are more likely to be used in that case. This means that the registers 14 must have at least a width of 10 bits and the counter 131 must be designed at least as a 10-bit counter. The ramp signal would then be incremented at least from 0-1023. If the same solution as described above is used, the ramp signal would be counted from 0-1024 and an 11-bit counter would be used and also registers 14 having a width of 11 bits. The shift register 16 must also be adapted accordingly.

The clock signal for ramp signal generation need not be particularly high in the case of the application of a digital camera, since it is not necessarily the case that a number of images are to be recorded per second. The requirements differ here for the case where the image recorder according to the invention is also intended to be used in a video camera. An A/D conversion with an 8-bit resolution suffices for this application, however. If the light-sensitive cells are likewise read out in rows, then the following requirement is made of the clock signal. An 8-bit resolution and a video line length of 64 µs results in a clock frequency of 256 × 1/64 µs, which leads to a clock frequency of 4 MHz. This is not, however, a problem for today's technology; it is rather a relatively low clock frequency compared with the clock frequencies that are customary in today's microprocessors. In video cameras, an image is scanned according to the known line interlacing method. This requires the row selector 12 to be designed correspondingly. To be precise, the row selector 12 must in each case select the next but one row when a reset signal arrives, if the converted data are intended to be transferred directly into a field memory. In addition, it must also be ensured that, at the end of one field, a changeover is made to the first line of the next field, the said line being arranged correspondingly offset. However, this problem has already been solved in the prior art and corresponding circuits are available. However, progressive image scanning can also be realized in a simple manner using the image recorder according to the invention, as explained above.

As a rule, the clock signal for the shift register 16 is different from the clock signal from the ramp signal generating unit 13. Specifically, it must be ensured that all the buffer-stored values are also read out within a ramp signal cycle and have been transferred into the RAM memory 30. A faster clock signal is then necessary for this purpose. This depends on how many light-sensitive cells 11 are arranged in an image line and on the resolution with which the A/D conversion is performed. By way of example, if more than 256 light sensors are provided in an image line given an 8-bit resolution, the clock signal for the shift register 16 must have a higher frequency than the conversion clock signal. By way of example, if there are 1024 light sensors in an image line, the clock signal of the shift register 16 should be 1024 × 1/64 µs 16 MHz in the case of a video camera application.

Diverse modifications of the exemplary embodiment explained here are possible, which are to be regarded as still being within the scope of the invention.

In the exemplary embodiment, the respective instantaneous value of the ramp signal is stored in a register. The term register should also be understood to mean other components which can store the instantaneous value. An example mentioned is a parallel-running counter which is stopped by the output signal of the light-sensitive cell and thus likewise buffer-stores the instantaneous value.

The ramp signal shown in Figure 5 has the form of a staircase having steps of the same size. In a development of the invention, the ramp signal may have a different form. By way of example, the staircase steps may have variable heights. If an 8-bit resolution, for example, is desired, the first 127 steps could be designed with a specific first step height and the remaining steps could be designed with a different step height. If the first step height is smaller than the second step height, adaptation of the conversion behaviour to the behaviour of the human eye is achieved in a simple manner. Specifically, the human eye responds less sensitively to changes in brightness if a certain basic brightness is exceeded. A finer resolution would thus be achieved in the lower brightness range. However, other range divisions are also appropriate. However, continuous variations of the step heights are also conceivable in order to achieve e.g. a logarithmic conversion behaviour.

Instead of the analogue values being converted in rows, it is alternatively possible to realize conversion in columns in a simple manner. For this purpose, instead of the row selector, a corresponding column selector must then be provided and the outputs of the light sensors 11 are combined in rows.

Furthermore, a plurality of rows or columns could also be evaluated in a combined fashion if this appears to be necessary in an application. In that case, a corresponding plurality of registers would have to be provided in the register block and the shift register would also have to be enlarged correspondingly. In principle the analogue values could also be converted pixel by pixel. In that case, either a very fast ramp signal would have to be generated in each case valid for one pixel, and just one register would need be provided, which, however, would have to be read out correspondingly rapidly, and the outputs 19 of the light-sensitive cells 11 would have to be able to be connected to the control input of the register via a multiplexer.

Another embodiment would be for a register to be provided separately in each case practically per light-sensitive cell 11. Even that would be feasible using CMOS technology. In that case, it would be necessary possibly to accept a reduction in the size of the pixel matrix.

## Claims

1. Image recorder (10) having a multiplicity of light-sensitive elements (11), having integrated means (113, 14, 13) for converting the analogue value stored in a light-sensitive element (11) into a digital value, in which case a comparator (113) is assigned per light-sensitive element (11), to which comparator the analogue value is fed at one input and a ramp signal is fed at the other input, **characterized in that** the output of the comparator (113) is connected to a trigger input of a register (14) having a width of N bits, where N is a natural number ≥ 2, and in that the output pulse of the comparator (113) causes the register (14) to buffer-store the instantaneous value of the ramp signal in digital form.

2. Image recorder (10) according to Claim 1, in which case the light-sensitive elements (11) are arranged in matrix form and can be addressed in rows or in columns by corresponding selectors (12) in such a way that the analogue values stored in the light-sensitive elements (11) are converted in rows or in columns, in which case there are as many registers (14) arranged in parallel as there are light-sensitive elements (11) provided in a row or column.

3. Image recorder according to Claim 1 or 2, in which case the ramp signal is restarted cyclically for the conversion of the analogue values of a row or column.

4. Image recorder according to one of Claims 1 to 3, in which case the ramp signal rises continuously in increments, from the value zero up to a maximum value, in which case the number of increments of the ramp signal corresponds to a value which is determined by the desired bit resolution for the A/D conversion.

5. Image recorder according to Claim 4, in which case the signal change per increment of the ramp signal is constant over the entire range of values.

6. Image recorder according to Claim 4, in which case the signal change per increment of the ramp signal is variable, in particular is smaller in a first region of the range of values than in a second region, in order to achieve adaptation of the conversion behaviour to the behaviour of the human eye.

7. Image recorder according to one of Claims 3 to 6, in which case a shift register (16) is provided, into which the entries of the registers (14) arranged in parallel are copied after the end of a ramp signal cycle.

8. Image recorder according to one of Claims 1-7, in which case the ramp signal is generated in a counter (131) with D/A converter (132) connected downstream.

9. Image recorder according to Claim 8, in which case the present counter reading of the counter (131) is passed to the inputs of the register/registers (14).

10. Image recorder according to one of Claims 2-9, in which case the image recorder (10) is designed for generating video images, the analogue values stored in the light-sensitive elements (11) being converted in rows and the cycle of the ramp signal corresponding to the duration of a video line.

11. Image recorder according to one of the preceding claims, in which case CMOS chip technology is used for the realization of the image recorder (10).
